# EUROPEAN PATENT APPLICATION

(11) **EP 4 749 916 A1**
(43) Date of publication of application: **27.05.2026**
(21) Application number: 24855245.7
(22) Date of filing: 06.03.2024
(51) Int. Cl.: H02S 40/32

(54) **POWER CONVERSION DEVICE AND PHOTOVOLTAIC SYSTEM**

(30) Priority: 24.08.2023 CN 202311076371
(71) Applicant: Huawei Digital Power Technologies Co., Ltd., Shenzhen, Guangdong 518043 (CN)
(72) Inventor: REN, Junheng, Shenzhen, Guangdong 518043 (CN); LI, Jiyang, Shenzhen, Guangdong 518043 (CN); HONG, Fangjun, Shenzhen, Guangdong 518043 (CN)
(74) Representative: Maiwald GmbH
(86) International application number: PCT/CN2024/080388
(87) International publication number: WO 2025/039514

(57) **Abstract**

This application provides a power conversion apparatus and a photovoltaic system, and relates to the field of energy technologies, to resolve a technical problem that a power conversion apparatus has poor heat dissipation effect. The power conversion apparatus provided in this application may include a circuit board, a power module, and a heat sink. The heat sink includes an evaporator and a condensation tooth. The evaporator includes an evaporation cavity, a first side wall, and a second side wall, the first side wall and the second side wall are disposed opposite to each other, and the evaporation cavity is located between the first side wall and the second side wall. There is a thermally conductive rib in the evaporation cavity, one end of the thermally conductive rib is connected to the first side wall, and the other end is connected to the second side wall. A condensation channel is provided in the condensation tooth, a first end of the condensation tooth is connected to an outer surface of the second side wall, and the condensation channel communicates with the evaporation cavity. A cooling working medium may circulate in a path including the evaporation cavity and the condensation channel. In the power conversion apparatus provided in this application, the cooling working medium may be used to dissipate heat of the power module in a heat transfer manner, so that the power conversion apparatus has good heat dissipation performance.

## Description

### CROSS-REFERENCE TO RELATED APPLICATIONS

This application claims priority to Chinese Patent Application No. 202311076371.3, filed with the China National Intellectual Property Administration on August 24, 2023 and entitled "POWER CONVERSION APPARATUS AND PHOTOVOLTAIC SYSTEM", which is incorporated herein by reference in its entirety.

### TECHNICAL FIELD

This application relates to the field of energy technologies, and in particular, to a power conversion apparatus and a photovoltaic system.

### BACKGROUND

With continuous development and wide popularization of green energy, importance of electric energy in people's daily life becomes increasingly prominent. In a process of transmitting and using the electric energy, a parameter such as a voltage or a current of the electric energy needs to be converted or adjusted. For example, a photovoltaic power generation device may include a solar panel and an inverter. The solar panel can convert solar energy into a direct current, and the inverter can convert the direct current generated by the solar panel into an alternating current and then output the alternating current to the outside. During actual use, the inverter generates much heat. Therefore, to ensure working performance and reliability of the inverter, heat dissipation needs to be performed on the inverter. Currently, heat dissipation is mainly performed on the inverter in an air cooling manner. To put it simply, a heat sink may be disposed on an outer surface of the inverter, heat of the inverter may be conducted to the heat sink in a heat transfer manner, and an external airflow may take away heat of the heat sink when flowing through a surface of the heat sink, to cool the inverter. However, as an operating power of the inverter continuously increases, a heat dissipation requirement of the inverter also increases significantly. Therefore, the heat dissipation requirement of the inverter cannot be met if heat dissipation is performed on the inverter by using the heat sink only in the air cooling manner. Therefore, how to improve heat dissipation performance of the heat sink becomes an urgent technical problem to be resolved.

### SUMMARY

This application provides a photovoltaic system and a power conversion apparatus having good heat dissipation performance.

According to a first aspect, this application provides a power conversion apparatus, where the power conversion apparatus may include a circuit board, a power module, and a heat sink. The power module is disposed on the circuit board, and the heat sink is disposed on a surface that is of the power module and that faces away from the circuit board. The heat sink includes an evaporator and a condensation tooth. The evaporator includes an evaporation cavity, a first side wall, and a second side wall, the first side wall and the second side wall are disposed opposite to each other in a first direction, and the evaporation cavity is located between the first side wall and the second side wall. The heat sink is in contact with the power module by using the first side wall, so that heat generated by the power module can be transferred to the heat sink by using the first side wall. The evaporation cavity includes a thermally conductive rib, one end of the thermally conductive rib is connected to the first side wall, and the other end is connected to the second side wall. A condensation channel is provided in the condensation tooth, a first end of the condensation tooth is connected to an outer surface of the second side wall, the condensation tooth extends in a direction facing away from a surface of the first side wall, and the extension direction of the condensation tooth is parallel to the first direction. The condensation channel communicates with the evaporation cavity, and a cooling working medium may circulate in a path including the evaporation cavity and the condensation channel.

In the power conversion apparatus provided in this application, the power module may be in heat conduction contact with the outer surface of the first side wall, so that the heat generated by the power module can be effectively transferred to the first side wall of the evaporator. In addition, the thermally conductive rib is provided, so that heat of the first side wall can be conducted to the second side wall in a heat transfer manner, to effectively improve heat dissipation efficiency of the first side wall and temperature uniformity of the evaporator. The condensation tooth is located on the second side wall, and heat of the second side wall can be effectively conducted to the condensation tooth in a heat transfer manner. The condensation tooth can provide a large heat dissipation area. Therefore, heat dissipation performance of the heat sink can be effectively improved. In addition, there is the cooling working medium in the evaporation cavity of the evaporator. A liquid cooling working medium absorbs heat in the evaporation cavity and then vaporizes, so that a temperature of the evaporator can be effectively reduced, to ensure heat transfer performance between the power module and the heat sink. A vaporized cooling working medium may enter the condensation channel, and release heat to condense in the condensation channel, so that a temperature of the cooling working medium can be effectively reduced. After the temperature of the cooling working medium is reduced, the cooling working medium is liquefied, and can return to the evaporation cavity, so that the cooling working medium circulates between the evaporation cavity and the condensation channel, and the heat sink has good heat dissipation performance.

In specific disposing, a surface that is of the first side wall and that faces away from the second side wall includes a thermally conductive region, the thermally conductive region is configured to be in heat conduction contact with the power module, and a projection of the thermally conductive rib on the first side wall overlaps a projection of the thermally conductive region on the first side wall. In this way, heat of the thermally conductive region can be conducted to the thermally conductive rib through a short heat transfer path. This helps improve heat dissipation performance of the thermally conductive region.

In an example, the condensation tooth may include a solid region, and the solid region extends from the first end of the condensation tooth to a second end of the condensation tooth. A projection of the solid region on the first side wall may overlap the projection of the thermally conductive region on the first side wall, to shorten a heat conduction path between the thermally conductive region and the solid region. The solid region has good heat conduction performance. This helps improve the heat dissipation performance of the thermally conductive region and the heat dissipation performance of the entire heat sink.

In specific disposing, the evaporator includes a plurality of thermally conductive ribs, and the plurality of thermally conductive ribs are sequentially disposed at intervals in a second direction. The second direction is parallel to a thickness direction of the thermally conductive rib.

When the plurality of thermally conductive ribs are disposed in the evaporation cavity, a passage may be formed between two adjacent thermally conductive ribs, and two adjacent passages communicate with each other, to facilitate effective circulation of the cooling working medium in the entire evaporation cavity.

In specific disposing, the heat sink may include a plurality of condensation teeth, the plurality of condensation teeth may be sequentially disposed at intervals in the second direction, and an air flow channel for air circulation is formed between two adjacent condensation teeth. The foregoing structure is disposed, so that there is a large heat exchange area between the condensation tooth and the air flow channel. This helps ensure heat dissipation efficiency of the condensation tooth.

In specific disposing, the heat sink may further include heat dissipation fins, and the heat dissipation fin is located in the air flow channel and is connected to an outer surface of the condensation tooth. Heat of the condensation tooth may be effectively transferred to the heat dissipation fin in a heat conduction manner. The heat dissipation fin has a large heat exchange area, and air flowing through the air flow channel can quickly take away heat of the heat dissipation fin, to effectively improve condensation efficiency of the cooling working medium in the condensation channel.

In an example, the heat sink may further include a condensation confluence cavity. The condensation confluence cavity is located on a side that is of the condensation tooth and that is away from the evaporator, and communicates with the condensation channel. The cooling working medium can release heat to condense in the condensation confluence cavity. Therefore, the condensation confluence cavity can have effective condensation effect on the cooling working medium. In addition, the condensation confluence cavity may further communicate with a plurality of condensation channels, and can effectively combine the cooling working medium.

In an example, the condensation channel may include a support rib. In a thickness direction of the condensation tooth, there are two side walls that are disposed opposite to each other in the condensation channel, and the support rib is connected between the two side walls. The support rib is disposed, so that structural strength of the condensation tooth can be improved. In addition, the support rib may further increase a contact area between the cooling working medium and the condensation tooth, thereby improving condensation effect of the cooling working medium.

In an example, at least a part of an inner wall of the evaporation cavity includes a capillary structure. A capillary force of the capillary structure may increase a return speed of the liquid cooling working medium, to ensure the heat dissipation performance of the heat sink and effectively prevent an adverse situation such as dry burning.

In an example, the evaporator may include a plurality of evaporation cavities, the heat sink includes a plurality of condensation teeth, and each evaporation cavity includes a condensation tooth correspondingly disposed. The plurality of evaporation cavities are disposed, so that a plurality of different power modules can be cooled relatively independently, there is good use flexibility, and heat dissipation effect of the different power modules are ensured.

In specific disposing, the power conversion apparatus may be a power converter or an inverter. A specific type of the power conversion apparatus is not limited in this application.

According to a second aspect, this application further provides a photovoltaic system. The photovoltaic system may include a power generation device and the foregoing power conversion apparatus. The power conversion apparatus is connected to the power generation device, and is configured to convert a direct current generated by the power generation device into an alternating current. The foregoing heat sink is provided, so that a power conversion component can be effectively cooled, and an adverse situation such as performance deterioration caused by an excessively high temperature of the power conversion component can be prevented. In this way, working performance and safety of the photovoltaic system are ensured.

### BRIEF DESCRIPTION OF DRAWINGS

FIG. 1 is a simple diagram of a structure of a conventional photovoltaic power generation device according to an embodiment of this application;
FIG. 2 is a diagram of a three-dimensional structure of a power conversion apparatus according to an embodiment of this application;
FIG. 3 is a diagram of a cross-sectional structure along A-A in FIG. 2;
FIG. 4 is a diagram of a cross-sectional structure along B-B in FIG. 2;
FIG. 5 is a diagram of a structure of an evaporator according to an embodiment of this application;
FIG. 6 is a diagram of a three-dimensional structure of a condensation tooth according to an embodiment of this application;
FIG. 7 is a diagram of a three-dimensional structure of another condensation tooth according to an embodiment of this application;
FIG. 8 is a diagram of a cross-sectional structure along C-C in FIG. 7;
FIG. 9 is a diagram of a structure of a side surface of a heat sink according to an embodiment of this application;
FIG. 10 is a diagram of a structure of a condensation tooth according to an embodiment of this application;
FIG. 11 is a diagram of a cross-sectional structure of a heat sink according to an embodiment of this application;
FIG. 12 is a diagram of a three-dimensional structure of another condensation tooth according to an embodiment of this application;
FIG. 13 is a diagram of a cross-sectional structure of another condensation tooth according to an embodiment of this application;
FIG. 14 is a diagram of a three-dimensional structure of another heat sink according to an embodiment of this application;
FIG. 15 is a diagram of a cross-sectional structure along D-D in FIG. 14;
FIG. 16 is a diagram of a structure of a condensation plate according to an embodiment of this application;
FIG. 17 is a diagram of a cross-sectional structure of a heat sink according to an embodiment of this application;
FIG. 18 is a diagram of a cross-sectional structure of an exploded structure of another heat sink according to an embodiment of this application; and
FIG. 19 is a block diagram of a structure of a photovoltaic system according to an embodiment of this application.

### DESCRIPTION OF EMBODIMENTS

To make objectives, technical solutions, and advantages of this application clearer, the following further describes this application in detail with reference to accompanying drawings.

For ease of understanding a heat sink provided in embodiments of this application, the following first describes an application scenario of the heat sink.

The heat sink provided in embodiments of this application may be used in a plurality of scenarios in which there is a heat dissipation requirement, and is configured to cool a power module, so that the power module is in a normal temperature range, to ensure working performance and safety of the power module.

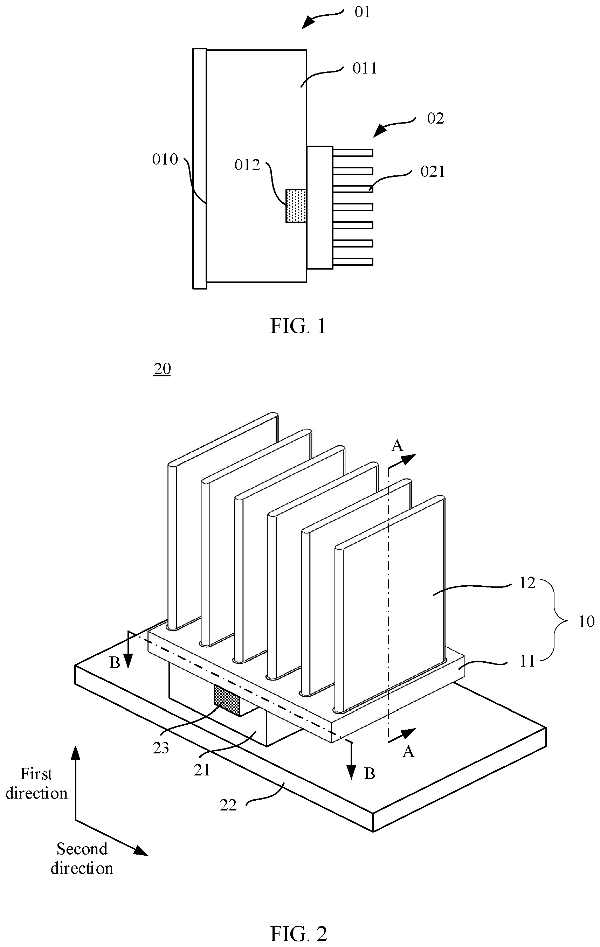

For example, as shown in FIG. 1, a photovoltaic power generation device may include a power conversion apparatus 01. The power conversion apparatus 01 can convert a direct current generated by a solar panel into an alternating current and then output the alternating current to the outside. During actual use, the power conversion apparatus 01 may include a circuit board 010 and a power module 011. The power module 011 is disposed on the circuit board 010 and is electrically connected to a conductive line in the circuit board 101. The power module 011 may include a component such as a power transistor 012. During actual application, the power module 011 generates much heat. Therefore, to ensure working performance and reliability of the power conversion apparatus 01, heat dissipation needs to be performed on the power module 011 in the power conversion apparatus 01. Currently, heat dissipation is mainly performed on the power module 011 in an air cooling manner. To put it simply, a heat sink 02 may be disposed at a position that is in the power module 011 and that corresponds to the power transistor 012. The heat sink 02 may include heat dissipation fins 021. When an air flow passes through a gap between the heat dissipation fins 021, heat of the heat dissipation fins 021 can be quickly taken away, to cool the power module 011. In summary, the heat generated by the power module 011 may be transferred to the heat sink fins 021 of the heat sink 02 in a heat conduction manner, and the airflow flowing through the heat dissipation fins 021 may quickly take away heat of the heat sink 02, to cool the power module 011.

However, as an operating power of the power conversion apparatus 01 continuously increases, a heat dissipation requirement of the power conversion apparatus 01 also increases significantly. Therefore, the heat dissipation requirement of the power conversion apparatus 01 cannot be met if heat dissipation is performed on the power conversion apparatus 01 by using the heat sink 02 only in the air cooling manner.

Therefore, embodiments of this application provide a power conversion apparatus having good heat dissipation performance.

To make the objectives, the technical solutions, and the advantages of this application clearer, the following further describes this application in detail with reference to the accompanying drawings and specific embodiments.

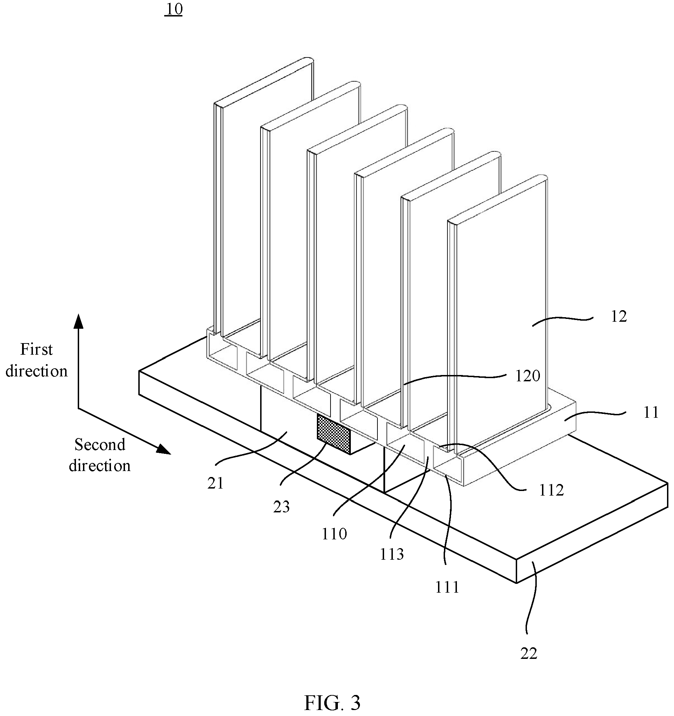

As shown in FIG. 2 and FIG. 3, in an example provided in this application, a power conversion apparatus 20 includes a power module 21, a circuit board 22, and a heat sink 10. The power module 21 is disposed on the circuit board 22 and is electrically connected to a conductive line in the circuit board 22. The power module 21 is configured to adjust parameters such as a voltage and/or a current of electric energy at an input end, and then output adjusted parameters from an output end. The heat sink 10 is disposed on a surface that is of the power module 21 and that faces away from the circuit board 22, and is configured to cool the power module 21. During actual application, the power module 21 has a packaging structure, and a power component 23 such as a power transistor or a power conversion circuit may be packaged inside the power module 21. A specific type and a specific quantity of power components 23 included in the power module 21 are not limited in this application.

The heat sink 10 may include an evaporator 11, a condensation tooth 12, and a cooling working medium (not shown in the figure). The evaporator 11 includes an evaporation cavity 110 configured to accommodate the cooling working medium. The evaporator 11 further includes a first side wall 111 and a second side wall 112. The first side wall 111 and the second side wall 112 are disposed opposite to each other in a first direction, and the evaporation cavity 110 is located between the first side wall 111 and the second side wall 112. The evaporation cavity 110 includes a thermally conductive rib 113, one end of the thermally conductive rib 113 is connected to the first side wall 111, and the other end is connected to the second side wall 112. Heat transfer between the first side wall 111 and the second side wall 112 can be implemented by using the thermally conductive rib 113, so that heat of the first side wall 111 can be efficiently transferred to the second side wall 112, and dissipated by using the second side wall 112. In addition, the condensation tooth 12 includes a condensation channel 120. A first end (for example, a lower end in the figure) of the condensation tooth 12 is connected to an outer surface of the second side wall 112. The condensation tooth 12 extends in a direction facing away from a surface of the first side wall 111, and the extension direction of the condensation tooth 12 is parallel to the first direction. The condensation channel 120 communicates with the evaporation cavity 110, and the cooling working medium may circulate in a path including the evaporation cavity 110 and the condensation channel 120.

In the heat sink 10 provided in this application, the power module 21 may be in heat conduction contact with a surface that is of the first side wall 111 and that faces away from the second side wall 112, so that heat generated by the power module 21 can be effectively transferred to the first side wall 111 of the evaporator 11. In addition, the thermally conductive rib 113 is provided, so that heat of the first side wall 111 can be conducted to the second side wall 112 in a heat transfer manner, to effectively improve heat dissipation efficiency of the first side wall 111 and temperature uniformity of the evaporator 11. The condensation tooth 12 is located on the second side wall 112, and heat of the second side wall 112 can be effectively conducted to the condensation tooth 12 in a heat transfer manner. The condensation tooth 12 can provide a large heat dissipation area. Therefore, heat dissipation performance of the heat sink 10 can be effectively improved. In addition, there is the cooling working medium in the evaporation cavity 110 of the evaporator 11. A liquid cooling working medium absorbs heat in the evaporation cavity 110 and then vaporizes, so that a temperature of the evaporator 11 can be effectively reduced, to ensure heat transfer performance between the power module 21 and the heat sink 10. A vaporized cooling working medium may enter the condensation channel 120, and release heat to condense in the condensation channel 120, so that a temperature of the cooling working medium can be effectively reduced. After the temperature of the cooling working medium is reduced, the cooling working medium is liquefied, and can return to the evaporation cavity 110, so that the cooling working medium circulates between the evaporation cavity 110 and the condensation channel 120, and the heat sink 10 has good heat dissipation performance.

In summary, in the heat sink 10 provided in this application, the temperature of the evaporator 11 may be reduced through heat absorption and vaporization of the liquid cooling working medium in the evaporator 11, to improve heat transfer efficiency between the power module 21 and the evaporator 11. In addition, the gaseous cooling working medium may be liquefied and release heat in the condensation channel 120, to effectively transfer heat in the evaporator 11 to the condensation tooth 12. In addition, the condensation tooth 12 has the large heat dissipation area. When external air flows through an outer surface of the condensation tooth 12, heat of the condensation tooth 12 can be quickly taken away, to accelerate liquefaction effect of the cooling working medium in the condensation channel 120, and effectively improve circulation efficiency of the cooling working medium. In addition, the thermally conductive rib 113 is connected between the first side wall 111 and the second side wall 112, so that the heat of the first side wall 111 can be effectively transferred to the second side wall 112. This helps reduce a temperature difference between the first side wall 111 and the second side wall 112, thereby improving the temperature uniformity of the entire evaporator 11. The condensation tooth 12 is disposed on the outer surface of the second side wall 112, so that the heat of the second side wall 112 can be effectively transferred to the condensation tooth 12 for dissipation. That is, the first side wall 111, the thermally conductive rib 113, the second side wall 112, and the condensation tooth 12 can form an effective heat transfer path, to effectively improve the heat dissipation efficiency of the first side wall 111, and further improve heat dissipation efficiency of the entire heat sink 10.

In specific disposing, the heat sink 10 may include one, two, or more condensation teeth 12.

For ease of understanding the technical solutions of this application, the following uses an example in which the heat sink 10 includes six condensation teeth 12 for description.

In specific disposing, the evaporator 11 may have various structure types.

For example, as shown in FIG. 2, in an example provided in this application, an overall appearance of the evaporator 11 is a rectangular plate structure, an internal structure of the evaporator 11 is a hollow structure, and internal space of the hollow structure forms the evaporation cavity 110. The evaporator 11 includes six side walls, areas of the first side wall 111 and the second side wall 112 are basically the same, and the first side wall 111 and the second side wall 112 each are a side wall with a large area in the evaporator 11. During actual application, when the power module 21 is cooled, the first side wall 111 can have a sufficient area for heat conduction contact with the power module 21, so that the heat dissipation performance of the heat sink 10 can be effectively improved. In addition, the second side wall 112 also has a sufficient area, so that more condensation teeth 12 can be disposed on the outer surface of the second side wall 112, and the heat dissipation performance of the heat sink 10 can be improved.

Moreover, a distance between the first side wall 111 and the second side wall 112 is small. When the thermally conductive rib 113 is connected between the first side wall 111 and the second side wall 112, in a connection direction of the first side wall 111 and the second side wall 112, the thermally conductive rib 113 has a small size, and can effectively shorten a heat conduction path between the first side wall 111 and the second side wall 112. The heat of the first side wall 111 can be efficiently transferred to the second side wall 112, to effectively improve the heat dissipation efficiency of the heat sink 10. In addition, it is also convenient to reduce the size of the thermally conductive rib 113, to help reduce a weight of the entire heat sink 10.

It may be understood that, in another example, the evaporator 11 may be a polyhedron such as a hollow cube, or may be in another irregular shape. During actual application, a structural shape of the evaporator 11 may be appropriately set and adjusted, and details are not described herein.

When the thermally conductive rib 113 is disposed, shapes, a specified quantity, and a position layout of thermally conductive ribs 113 may be diversified.

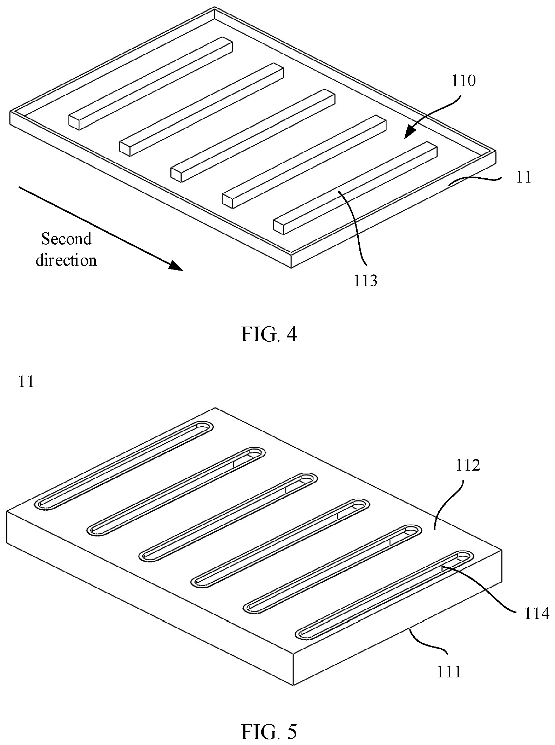

For example, as shown in FIG. 4, in an example provided in this application, the heat sink 10 includes five thermally conductive ribs 113, and each thermally conductive rib 113 is in a straight strip shape. In addition, the plurality of thermally conductive ribs 113 are sequentially disposed at intervals in a second direction. The second direction is parallel to a thickness direction of the thermally conductive rib 113. The thermally conductive rib 113 is disposed, so that structural strength and the temperature uniformity of the evaporator 11 can be effectively improved.

Specifically, as shown in FIG. 3, in a thickness direction of the evaporator 11, the thermally conductive rib 113 is connected between the first side wall 111 and the second side wall 112, and can effectively connect and support the first side wall 111 and the second side wall 112. When the first side wall 111 or the second side wall 112 of the evaporator 11 is subject to an external squeezing force, the thermally conductive rib 113 can effectively resist the external squeezing force, to improve pressure resistance performance of the evaporator 11. In addition, the thermally conductive rib 113 is fastened to the first side wall 111 and the second side wall 112. When pressure in the evaporation cavity 110 is large, the thermally conductive rib 113 can effectively connect the first side wall 111 and the second side wall 112, to prevent the first side wall 111 and the second side wall 112 from an adverse situation such as protrusion, to effectively improve explosion-proof performance of the evaporator 11.

It may be understood that, in specific disposing, a connection between the thermally conductive rib 113 and the first side wall 111 or the second side wall 112 may alternatively be disposed in a non-fastening manner.

For example, the thermally conductive rib 113 may be fastened to the first side wall 111 and abut against the second side wall 112. Alternatively, the thermally conductive rib 113 may be fastened to the second side wall 112 and abut against the first side wall 111. Alternatively, the thermally conductive rib 113 may abut against both the first side wall 111 and the second side wall 112. The thermally conductive rib 113 may be effectively fastened in the evaporation cavity 110 by using a squeezing force between the first side wall 111 and the second side wall 112, so that an adverse situation such as position deviation of the thermally conductive rib 113 is prevented.

In addition, in the thickness direction of the evaporator 11, the heat of the first side wall 111 can be effectively transferred to the second side wall 112 by using the thermally conductive rib 113, so that the temperature difference between the first side wall 111 and the second side wall 112 can be effectively reduced, to improve temperature uniformity of the evaporator 11 in the thickness direction. In addition, the heat may be further transferred in a length direction of the thermally conductive rib 113. Therefore, heat of a local hot spot can be effectively diffused, and the temperature uniformity of the evaporator 11 can be further improved.

During manufacturing, the thermally conductive rib 113 may be a mechanical member that is independently manufactured and formed, and then the thermally conductive rib 113 is placed in the evaporation cavity 110. Alternatively, the thermally conductive rib 113 and the first side wall 111 or the thermally conductive rib 113 and the second side wall 112 may be an integrally formed mechanical member. A manufacturing manner of the evaporator 11 is not limited in this application.

In addition, as shown in FIG. 4, in an example provided in this application, in the length direction of the thermally conductive rib 113, neither end of the thermally conductive rib 113 extends to an inner wall of the evaporation cavity 110, so that the thermally conductive rib 113 can be prevented from obviously blocking normal flow of the cooling working medium. For example, the thermally conductive rib 113 can divide the evaporation cavity 110 to some extent, and a passage structure can be formed between two adjacent thermally conductive ribs 113. Because neither end of the thermally conductive rib 113 extends to the inner wall of the evaporation cavity 110, passage structures on two sides of the thermally conductive rib 113 communicate with each other. That is, cooling working media located on the two sides of the thermally conductive rib 113 can effectively flow from the two ends of the thermally conductive rib 113, to effectively ensure effective flow of the cooling working medium in the entire evaporation cavity 110.

In another example, two ends of the thermally conductive rib 113 may alternatively extend to an inner wall of the evaporation cavity 110, and a structure such as a notch may be disposed in a middle part of the thermally conductive rib 113 or at another position, so that cooling working media located on two sides of the thermally conductive rib 113 can flow through the notch, to ensure effective circulation of the cooling work.

In specific disposing, a specified quantity and positions of notches may be flexibly adjusted according to an actual requirement. This is not limited in this application.

In addition, in another example, the thermally conductive rib 113 may alternatively have a structure in a long strip shape such as a curve shape or a broken line shape or may have a structure such as a bump. During actual application, a shape of the thermally conductive rib 113 may be flexibly set and adjusted according to an actual requirement, and details are not described herein.

In addition, as shown in FIG. 5, to facilitate effective communication between the evaporation cavity 110 and the condensation channel 120, in an example provided in this application, the second side wall 112 includes a through hole 114 communicating with the evaporation cavity 110.

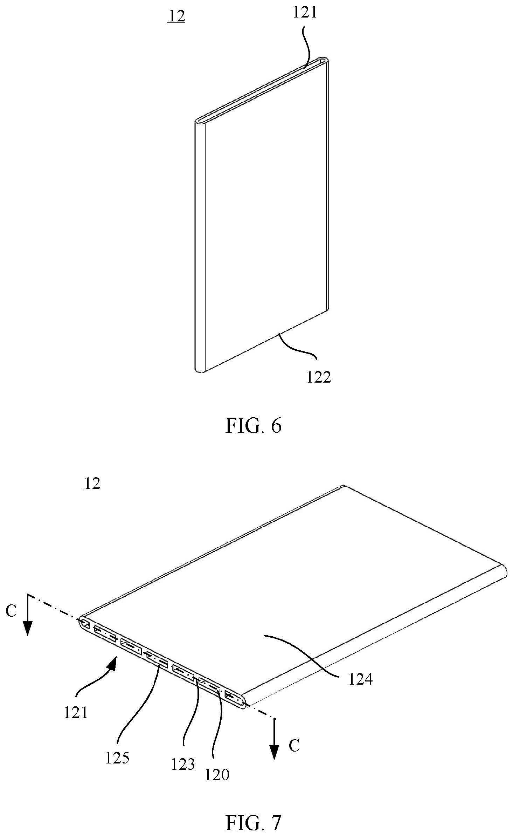

As shown in FIG. 6, the condensation tooth 12 has a hollow sheet structure, and the condensation tooth 12 includes a first end 121 and a second end 122 that are opposite to each other. Internal space of the condensation tooth 12 forms the condensation channel 120. The first end 121 includes a port communicating with the condensation channel 120, and the second end 122 has a closed structure.

Refer to FIG. 3, FIG. 5, and FIG. 6. In specific disposing, the first end 121 of the condensation tooth 12 may be fastened to the surface of the second side wall 112. In addition, the port of the first end 121 is connected to the through hole 114, to implement communication between the condensation channel 120 and the evaporation cavity 110.

In a specific implementation, the condensation tooth 12 may be fastened to the evaporator 11 in a manner such as welding or bonding. Alternatively, the condensation tooth 12 and the second side wall 112 may have an integrated structure. A manner of disposing the condensation tooth 12 and the evaporator 11 is not limited in this application.

When the condensation tooth 12 is manufactured, the condensation tooth 12 may be manufactured by using a process such as plate bending molding or welding, or may be manufactured in a manner for manufacturing a profile, such as hot pressing molding, cold drawing molding, cold extrusion molding, or hot extrusion molding. A specific manufacturing process of the condensation tooth 12 is not limited in this application.

In addition, in another example, a cross section of the condensation tooth 12 may alternatively be in a shape of a circle, an ellipse, a polygon, or another irregular shape. During actual application, a specific shape of the condensation tooth 12 may be appropriately selected and set according to an actual requirement, and details are not described herein.

In addition, in some examples, a capillary structure may be disposed on the inner wall of the evaporation cavity 110. A capillary force of the capillary structure may increase a return speed of the liquid cooling working medium, to ensure the heat dissipation performance of the heat sink 10 and effectively prevent an adverse situation such as dry burning.

In specific disposing, an inner wall of the condensation channel 120 may be a smooth surface. Alternatively, in some examples, a capillary structure may also be disposed on an inner wall of the condensation channel 120, and the capillary structure in the condensation channel 120 may be connected to the capillary structure in the evaporation cavity 110. After the cooling working medium is condensed in the condensation channel 120, the cooling working medium can effectively return to the evaporation cavity 110 through the capillary structure, so that the return speed of the cooling working medium is increased.

The capillary structure may be specifically meshed, granular, or the like. During actual application, a currently commonly used type may be selected for the capillary structure, and details are not described herein.

During specific application, an internal structure of the condensation tooth 12 may be a hollow structure shown in FIG. 6. Alternatively, in some examples, a reinforcing structure may alternatively be disposed in the condensation channel 120 in the condensation tooth 12.

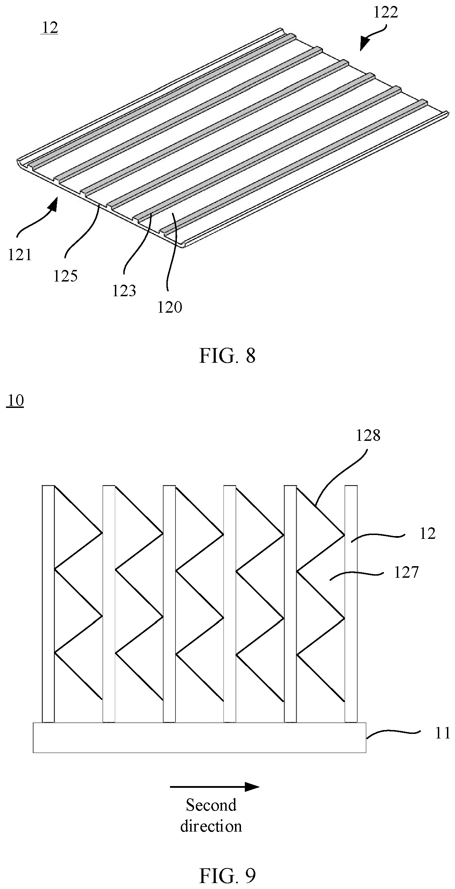

For example, as shown in FIG. 7 and FIG. 8, in an example provided in this application, there are support ribs 123 in the condensation channel 120. In a thickness direction of the condensation tooth 12, there is a side wall 124 and a side wall 125 that are disposed opposite to each other in the condensation channel 120, and the support rib 123 is connected between the side wall 124 and the side wall 125.

Specifically, the support rib 123 is in a straight strip shape and extends in a direction of the first end 121 and the second end 122 of the condensation tooth 12. The plurality of support ribs 123 are disposed in parallel and at intervals, and each support rib 123 may be connected to an inner wall 124 and a side wall 125 that are disposed opposite to each other in the condensation tooth 12. The support rib 123 can improve structural strength of the condensation tooth 12, to improve a pressure resistance capability of the condensation tooth 12.

In addition, after the support ribs 123 are disposed in the condensation channel 120 in the condensation tooth 12, the condensation channel 120 is divided into a plurality of channels parallel to each other by the support rib 123. The support ribs 123 are disposed, so that a contact area between the cooling working medium and the condensation tooth 12 can be increased, to improve condensation effect of the cooling working medium. In specific disposing, specific structures, a quantity, and a position arrangement of the support ribs 123 may be appropriately selected and adjusted according to an actual requirement. This is not limited in this application.

In addition, as shown in FIG. 9, in an example provided in this application, the heat sink 10 includes a plurality of condensation teeth 12, the plurality of condensation teeth 12 are sequentially disposed at intervals in the second direction, and an air flow channel 127 for air circulation is formed between two adjacent condensation teeth 12. The second direction is parallel to a thickness direction of the condensation tooth 12. The air flow channel 127 is formed between the two adjacent condensation teeth 12. The foregoing structure is disposed, so that there is a large heat exchange area between the condensation tooth 12 and the air flow channel. This helps ensure heat dissipation efficiency of the condensation tooth 12. During specific application, the heat sink 10 may further include a fan. The fan may be disposed at an end of the air flow channel 127, and is configured to accelerate a flow speed of air in the air flow channel 127, to improve the heat dissipation performance of the heat sink 10. Disposing positions and a quantity of fans may be flexibly adjusted according to an actual requirement. This is not limited in this application.

In addition, as shown in FIG. 9, in an example provided in this application, the heat sink 10 further includes heat dissipation fins 128. The heat dissipation fin 128 is located in the air flow channel 127, and is connected to the outer surface of the condensation tooth 12. The heat of the condensation tooth 12 may be effectively transferred to the heat dissipation fin 128 in a heat conduction manner. The heat dissipation fin 125 has a large heat exchange area, and the air flowing through the air flow channel 127 can quickly take away heat of the heat dissipation fin 128, to effectively improve condensation efficiency of the cooling working medium in the condensation channel 120.

During actual application, the heat dissipation fin 128 may be fastened between two adjacent condensation teeth 12, so that overall integration and structural strength of an assembly of condensation teeth 12 can be effectively improved. During actual application, the assembly of the condensation teeth 12 may be assembled as a whole.

In specific disposing, the heat dissipation fin 128 may have various structure types.

For example, as shown in FIG. 9, the heat dissipation fin 128 may have a bent sheet structure.

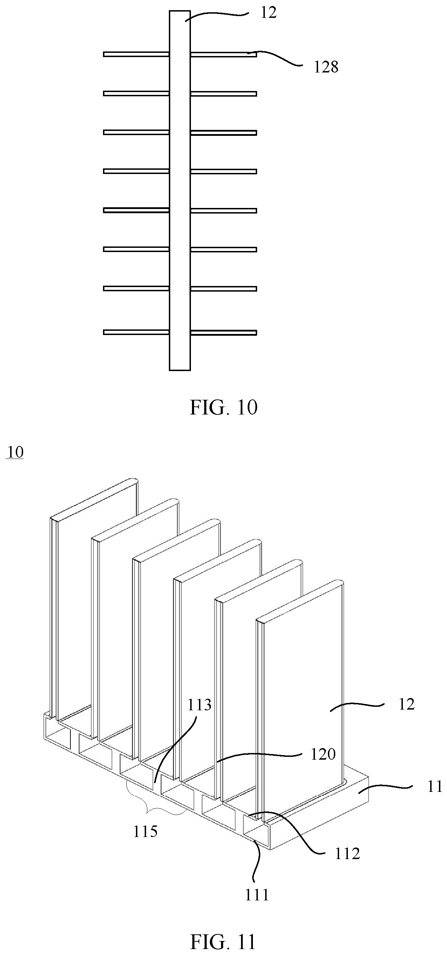

Alternatively, as shown in FIG. 10, the heat dissipation fin 128 may have a flat sheet structure.

During actual application, the heat dissipation fin 128 may be independently manufactured and formed, and then fastened to the condensation tooth 12 in a manner such as welding.

Alternatively, the heat dissipation fin 128 and the condensation tooth 12 may be manufactured by using an integrated molding process.

During actual application, a specific structure type and a manufacturing manner of the heat dissipation fin 128 may be appropriately selected and adjusted, and details are not described herein.

As shown in FIG. 11, during specific application, the entire outer surface of the first side wall 111 of the evaporator 11 may be in heat conduction contact with the power module. Alternatively, a partial region of the outer surface of the first side wall 111 may be in heat conduction contact with the power module.

For ease of understanding, in the following example, the region that is of the first side wall 111 and that is in contact with the power module is defined as a thermally conductive region 115.

During actual application, any region of the outer surface of the first side wall 111 may be used as the thermally conductive region 115. In addition, the first side wall 111 may include one thermally conductive region 115, or may include two or more thermally conductive regions 115.

During use, one thermally conductive region 115 may be in heat conduction contact with one power module. Alternatively, one thermally conductive region 115 may be in heat conduction contact with two or more power modules, and details are not described herein.

When the thermally conductive rib 113 is specifically disposed, a projection of the thermally conductive rib 113 on the first side wall 111 overlaps a projection of the thermally conductive region 115 on the first side wall 111. Specifically, for one thermally conductive rib 113, a projection of the thermally conductive rib 113 on the first side wall 111 may be located in a projection region of the thermally conductive region 115 on the first side wall 111, or a projection of at least a part of the thermally conductive rib 113 on the first side wall 111 is located in a projection region of the thermally conductive region 115 on the first side wall 111. In this way, heat of the thermally conductive region 115 can be effectively transferred to the second side wall 112 by using the thermally conductive rib 113, so that there is a short heat conduction path, and thermally conductive performance of the evaporator 11 can be effectively improved.

It should be noted that, during actual application, the evaporator 11 may include a plurality of thermally conductive ribs 113. In the plurality of thermally conductive ribs 113, a projection of one thermally conductive rib 113 on the first side wall 111 may overlap a projection region of the thermally conductive region 115 on the first side wall 111. Alternatively, projections of two or more thermally conductive ribs 113 on the first side wall 111 may overlap a projection region of the thermally conductive region 115 on the first side wall 111.

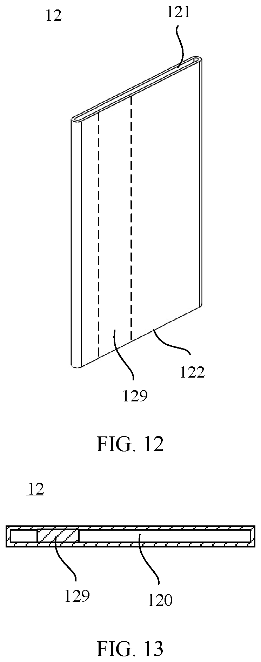

In addition, as shown in FIG. 12 and FIG. 13, when the condensation tooth 12 is specifically disposed, the condensation tooth 12 may include a solid region 129, and one end of the solid region 129 may extend to the first end 121 of the condensation tooth 12. In addition, a projection of the solid region 129 on the first side wall 111 overlaps the projection region of the thermally conductive region 115 on the first side wall 111. Specifically, for one condensation tooth 12, a projection of a solid region 129 of the condensation tooth 12 on the first side wall 111 may be located in the projection region of the thermally conductive region 115 on the first side wall 111, or a projection of at least a part of a solid region 129 on the first side wall 111 is located in the projection region of the thermally conductive region 115 on the first side wall 111. In this way, the heat of the thermally conductive region 115 can be effectively transferred to the solid region 129 of the condensation tooth 12, to improve the heat dissipation efficiency of the heat sink 10. The solid region 129 is a solid structure that is in the condensation tooth 12 and that is not provided with the condensation channel 120.

Refer to FIG. 11 and FIG. 12. In specific disposing, projections of the solid region 129 and the thermally conductive rib 113 on the first side wall 111 may overlap the projection region of the thermally conductive region 115 on the first side wall 111.

That is, the thermally conductive region 115 of the first side wall 111, the thermally conductive rib 113, the second side wall 112, and the solid region 129 may form a short heat conduction path, so that the heat of the thermally conductive region 115 can be effectively transferred to the solid region for heat dissipation by using the thermally conductive rib 113 and the second side wall 112. In this way, there is good heat conduction efficiency, and the heat dissipation efficiency of the heat sink 10 can be improved.

It should be noted that, during actual application, the evaporator 11 may include a plurality of condensation teeth 12. In the plurality of condensation teeth 12, a projection of a solid region 129 of one condensation tooth 12 on the first side wall 111 may overlap the projection region of the thermally conductive region 115 on the first side wall 111. Alternatively, projections of solid regions 129 of two or more condensation teeth 12 on the first side wall 111 may overlap the projection region of the thermally conductive region 115 on the first side wall 111.

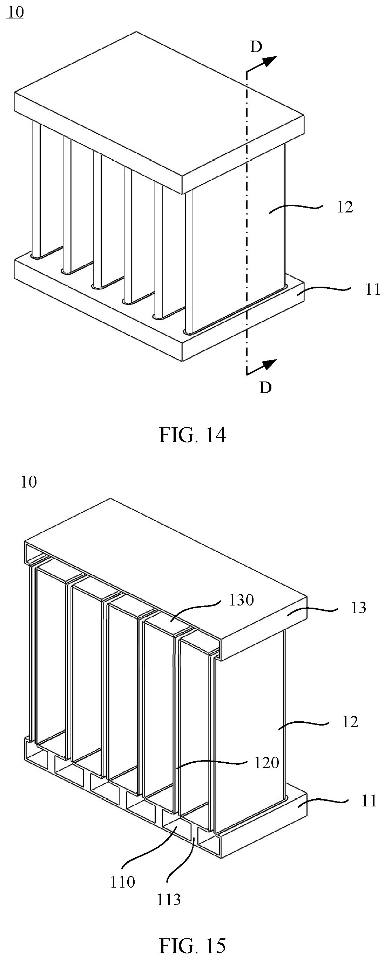

In addition, as shown in FIG. 14 and FIG. 15, in an example provided in this application, the heat sink 10 further includes a condensation confluence cavity 130. The condensation confluence cavity 130 is located on a side that is of a condensation tooth 12 and that is away from the evaporator 11, and communicates with a condensation channel 120.

Specifically, in an example provided in this application, an overall appearance of a condensation plate 13 is a rectangular plate structure, an internal structure of the condensation plate 13 is a hollow structure, and internal space of the hollow structure forms the condensation confluence cavity 130.

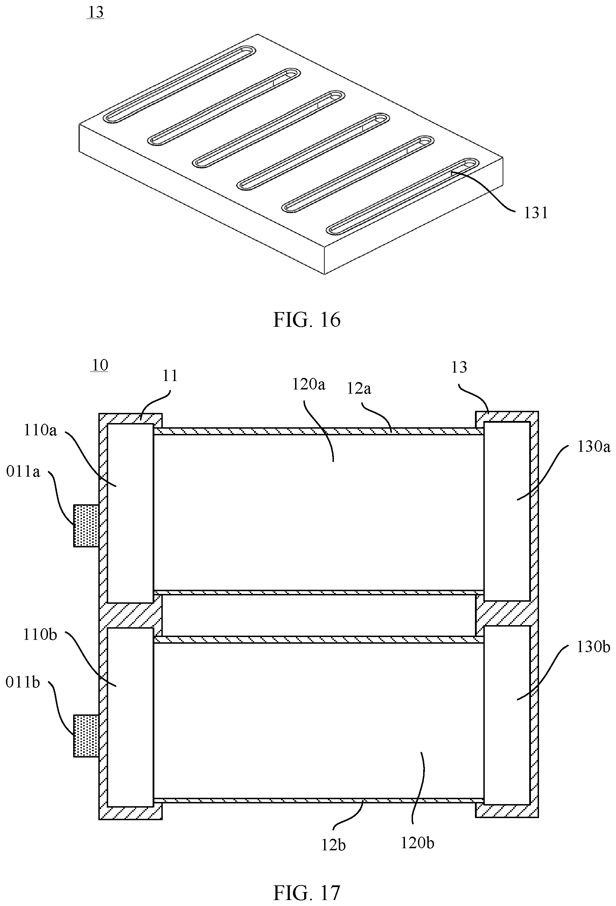

In addition, as shown in FIG. 16, to facilitate effective communication between the condensation confluence cavity 130 and the condensation channel 120, in an example provided in this application, a surface of the condensation plate 13 includes a through hole 131 communicating with the condensation confluence cavity 130.

As shown in FIG. 15, the condensation tooth 12 has a hollow sheet structure, and includes a first end (for example, a lower end in FIG. 15) and a second end (for example, an upper end in FIG. 15) that are opposite to each other. Internal space of the condensation tooth 12 forms the condensation channel 120. The second end of the condensation tooth 12 has an open structure, and a port of the second end is configured to connect to the through hole 131 of the condensation confluence cavity 130.

In specific disposing, the second end of the condensation tooth 12 may be fastened to the surface of the condensation plate 13. In addition, the port of the second end is connected to the through hole 131, to implement communication between the condensation channel 120 and the condensation confluence cavity 130.

A gaseous cooling working medium can release heat to condense in the condensation confluence cavity 130. Therefore, the condensation confluence cavity 130 can have effective condensation effect on the cooling working medium.

In addition, the condensation confluence cavity 130 may further communicate with a plurality of condensation channels 120, and can effectively combine the cooling working medium.

The condensation plate 13 can provide a condensation confluence cavity 130 with a large volume, and the condensation confluence cavity 130 can accommodate a large quantity of gaseous cooling working media, to help reduce a volume of the evaporator 11. Alternatively, it may be understood that, during actual application, to ensure vaporization effect of the cooling working medium, the cooling working medium cannot fully fill the entire evaporation cavity 110; otherwise, it is not conducive to effective conversion from the liquid working medium to the gaseous working medium. In an example provided in this application, the condensation confluence cavity 130 is provided, so that effective accommodation space can be provided for the gaseous cooling working medium, to help reduce the volume of the evaporator 11. In addition, vaporization effect of the liquid cooling working medium in the evaporation cavity 110 can be further ensured.

In addition, the condensation confluence cavity 130 can accommodate a large quantity of liquid cooling working media, to help reduce the volume of the evaporator 11. Alternatively, it may be understood that, during actual application, to ensure heat dissipation performance of the evaporator 11, a large evaporation cavity 110 needs to be provided in the evaporator 11 to ensure that a sufficient cooling working medium is included, to prevent an adverse situation such as dry burning. In an example provided in this application, the condensation confluence cavity 130 is provided, so that effective accommodation space can be provided for the liquid cooling working medium, and the liquid cooling working medium can be effectively transferred to the evaporation cavity 110. Therefore, an adverse situation such as dry burning of the evaporator 11 can be effectively prevented, and the volume of the evaporator 11 can be reduced.

In addition, in the foregoing example, an example in which the heat sink 10 includes one evaporation cavity 110 and one condensation confluence cavity 130 is used for description. However, in another example, the heat sink 10 may alternatively include two or more evaporation cavities 110, or may include two or more condensation confluence cavities 130.

For example, as shown in FIG. 17, in an example provided in this application, the evaporator 11 includes two evaporation cavities, and the condensation plate 13 includes two condensation confluence cavities. Specifically, the two evaporation cavities are an evaporation cavity 110a and an evaporation cavity 110b, and the two condensation confluence cavities are a condensation confluence cavity 130a and a condensation confluence cavity 130b.

The evaporation cavity 110a communicates with the condensation confluence cavity 130a through a condensation channel 120a in a condensation tooth 12a. The evaporation cavity 110b communicates with the condensation confluence cavity 130b through a condensation channel 120b in a condensation tooth 12b.

The evaporator 11 includes two thermally conductive regions. One of the thermally conductive regions is disposed corresponding to the evaporation cavity 110a, and the thermally conductive region is configured to be in heat conduction contact with a power module 011a. The other one of the thermally conductive regions is disposed corresponding to the evaporation cavity 110b, and the thermally conductive region is configured to be in heat conduction contact with a power module 011b.

Certainly, in another example, the evaporator 11 may alternatively include three or more evaporation cavities. The condensation plate may alternatively include three or more condensation confluence cavities. In addition, a specified quantity of evaporation cavities may be the same as or different from a specified quantity of confluence cavities. Details are not described herein.

In summary, during actual application, the evaporator 11 includes a plurality of evaporation cavities, and each evaporation cavity has a condensation tooth 12 correspondingly disposed. In addition, the condensation plate 13 may include a plurality of condensation confluence cavities, and each condensation confluence cavity has a condensation tooth 12 correspondingly disposed.

In a specific implementation, the condensation tooth 12 may be fastened to the condensation plate 13 in a manner such as welding or bonding.

Alternatively, the condensation plate 13, the condensation tooth 12, and the evaporator 11 may have an integrated structure.

The following uses the evaporator 10 shown in FIG. 14 as an example for description.

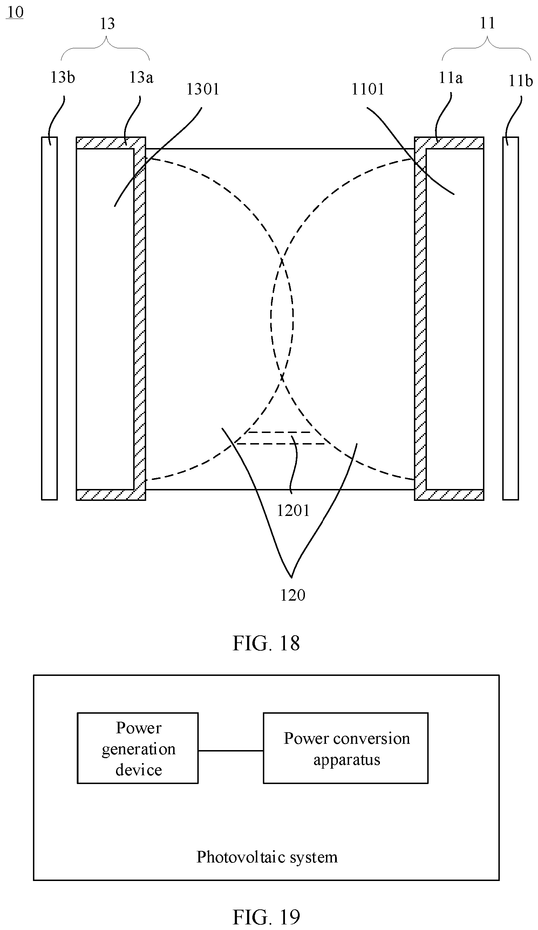

Specifically, with reference to FIG. 14 and FIG. 18, in an example provided in this application, the condensation plate 13, the condensation tooth 12, and the evaporator 11 may be manufactured in a manner for manufacturing a profile, such as hot pressing molding, cold drawing molding, cold extrusion molding, or hot extrusion molding.

The condensation plate 13 may include a bottom plate 13a and a cover plate 13b, and the evaporator 11 may also include a bottom plate 11a and a cover plate 11b.

The bottom plate 13a includes a groove 1301, and after the cover plate 13b seals the groove 1301 in the bottom plate 13a, a condensation confluence cavity may be formed.

The bottom plate 11a includes a groove 110a, and a groove bottom of the groove 110a includes a thermally conductive rib (not shown in the figure). After the cover plate 11b seals the groove 1101 in the bottom plate 11a, an evaporation cavity may be formed.

During further processing, semicircular cutting may be performed from a side that is of the bottom plate 13a and that is away from the condensation tooth 12 by using a metal slitting saw, and semicircular cutting may be performed from a side that is of the bottom plate 11a and that is away from the condensation tooth 12. Two semicircles intersect and pass through to hollow the condensation tooth 12, to form the condensation channel 120. This implements low-cost processing of the condensation tooth 12. In addition, through holes communicating with the condensation channel 120 are also cut in the bottom plate 11a and the bottom plate 13a, to implement communication between the condensation channel 120 and the evaporation cavity and the condensation confluence cavity. In addition, during actual manufacturing, a maximum depth of cut of the circular metal slitting saw is approximately a radius of the metal slitting saw. Therefore, to expand a width of the condensation channel 120, an additional drill may be used to further process a return hole 1201 inside the condensation tooth 12.

Finally, the cover plate 13b may seal the groove 1301 of the bottom plate 13a, and the cover plate 11b may seal the groove 1101 of the bottom plate 11a, to complete manufacturing of the heat sink 10.

In the foregoing manufacturing manner, the bottom plate 11a, the bottom plate 13a, and the condensation tooth 12 may be integrally formed, to avoid a connection structure such as a welding seam between the condensation tooth 12 and the bottom plate 11a or between the condensation tooth 12 and the bottom plate 13a, and effectively improve structural safety and reliability of the evaporator 10.

It may be understood that the foregoing manufacturing manner is merely an example for description. During actual application, the heat sink 10 may alternatively be manufactured in another manner. A manufacturing manner and a process of the heat sink 10 are not limited in this application.

During actual application, the power conversion component 22 may be specifically a power transistor, a power conversion circuit, or the like. Alternatively, the power conversion apparatus 20 may be specifically a power converter, an inverter, or the like. A specific type of the power conversion component 22 or the power conversion apparatus 20 is not limited in this application.

In addition, during actual application, the power conversion apparatus 20 may alternatively include a plurality of power conversion components 22, and each power conversion component 22 may be thermally conductively connected to the thermally conductive region of the evaporator 11. Alternatively, it may be understood that an outer surface of the evaporator 11 may include a plurality of thermally conductive regions, and each thermally conductive region may be thermally conductively connected to a corresponding power conversion component 22.

During actual application, the power conversion apparatus 20 may be used in a plurality of scenarios in which electric energy needs to be adjusted and controlled.

For example, as shown in FIG. 19, embodiments of this application further provide a photovoltaic system. The photovoltaic system may include a power generation device and a power conversion apparatus. The power conversion apparatus may be connected to the power generation device, and is configured to effectively process electric energy generated by the power generation device, to output processed electric energy to the outside.

During actual application, the power generation device may be specifically a solar panel. The solar panel may generate a direct current, and the power conversion apparatus may convert the direct current generated by the solar panel into an alternating current and then output the alternating current to the outside.

Certainly, in another example, the photovoltaic system may alternatively include a battery, a battery management system, and the like. In addition, during actual application, the power conversion apparatus may be used in a plurality of scenarios in which electric energy needs to be adjusted and controlled. A specific application scenario of the power conversion apparatus is not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

"A plurality of" in this application means two or more than two. "And/or" describes an association relationship between associated objects and indicates that three relationships may exist. For example, A and/or B may indicate the following three cases: Only A exists, both A and B exist, and only B exists, where A and B each may be singular or plural.

It may be understood that various numbers in embodiments of this application are merely used for differentiation for ease of description, and are not used to limit a scope of embodiments of this application. Sequence numbers of the foregoing processes do not mean execution sequences, and the execution sequences of the processes should be determined based on functions and internal logic of the processes.

## Claims

1. A power conversion apparatus, comprising a circuit board, a power module, and a heat sink, wherein the power module is disposed on the circuit board, and the heat sink is disposed on a surface that is of the power module and that faces away from the circuit board;
the heat sink comprises an evaporator and a condensation tooth, the evaporator comprises an evaporation cavity, a first side wall, and a second side wall, the first side wall and the second side wall are disposed opposite to each other in a first direction, the evaporation cavity is located between the first side wall and the second side wall, and the heat sink is in contact with the power module by using the first side wall;
the evaporation cavity comprises a thermally conductive rib, one end of the thermally conductive rib is connected to the first side wall, and the other end is connected to the second side wall; and
a condensation channel is provided in the condensation tooth, a first end of the condensation tooth is connected to an outer surface of the second side wall, the condensation tooth extends in a direction facing away from an outer surface of the first side wall, the extension direction of the condensation tooth is parallel to the first direction, and the condensation channel communicates with the evaporation cavity.

2. The power conversion apparatus according to claim 1, wherein the heat sink comprises a thermally conductive region, the thermally conductive region is disposed on a surface that is of the first side wall and that faces away from the second side wall, the first side wall is in contact with the power module by using the thermally conductive region, and a projection of the thermally conductive rib on the first side wall overlaps a projection of the thermally conductive region on the first side wall.

3. The power conversion apparatus according to claim 1 or 2, wherein the condensation tooth comprises a solid region, and the solid region extends from the first end of the condensation tooth to a second end of the condensation tooth; and
the surface that is of the first side wall and that faces away from the second side wall comprises the thermally conductive region, and a projection of the solid region on the first side wall overlaps the projection of the thermally conductive region on the first side wall.

4. The power conversion apparatus according to any one of claims 1 to 3, wherein the evaporator has a plurality of thermally conductive ribs, the plurality of thermally conductive ribs are sequentially disposed at intervals in a second direction, and the second direction is parallel to a thickness direction of the thermally conductive rib.

5. The power conversion apparatus according to claim 4, wherein a passage is formed between two adjacent thermally conductive ribs, and two adjacent passages communicate with each other.

6. The power conversion apparatus according to any one of claims 1 to 5, wherein the heat sink has a plurality of condensation teeth, the plurality of condensation teeth are sequentially disposed at intervals in the second direction, and an air flow channel for air circulation is formed between two adjacent condensation teeth.

7. The power conversion apparatus according to claim 6, wherein the heat sink further comprises heat dissipation fins, and the heat dissipation fin is located in the air flow channel and is connected to an outer surface of the condensation tooth.

8. The power conversion apparatus according to any one of claims 1 to 7, wherein the heat sink further comprises a condensation confluence cavity; and
the condensation confluence cavity is located on a side that is of the condensation tooth and that is away from the evaporator, and communicates with the condensation channel.

9. The power conversion apparatus according to any one of claims 1 to 8, wherein the condensation channel comprises a support rib; and
in a thickness direction of the condensation tooth, there are two side walls that are disposed opposite to each other in the condensation channel, and the support rib is connected between the two side walls.

10. The power conversion apparatus according to any one of claims 1 to 9, wherein at least a part of an inner wall of the evaporation cavity comprises a capillary structure.

11. The power conversion apparatus according to any one of claims 1 to 10, wherein the evaporator has a plurality of evaporation cavities, and the heat sink comprises a plurality of condensation teeth; and
each evaporation cavity has a condensation tooth correspondingly disposed.

12. The power conversion apparatus according to any one of claims 1 to 11, wherein the power conversion apparatus is a power converter or an inverter.

13. A photovoltaic system, comprising a power generation device and the power conversion apparatus according to any one of claims 1 to 12, wherein the power conversion apparatus is connected to the power generation device, and is configured to convert a direct current generated by the power generation device into an alternating current.
